# EUROPÄISCHE PATENTSCHRIFT

(11) **EP 0 560 085 B1**
(45) Veröffentlichungstag und Bekanntmachung des Hinweises auf die Patenterteilung: **17.09.1997**
(21) Anmeldenummer: 93102345.1
(22) Anmeldetag: 15.02.1993
(51) Int. Cl.: H01L 21/225

(54) **Verfahren zum Herstellen eines Aluminium-Dotierungsprofils**
Method for forming an aluminium doping profile
Procédé de formation d'un profil de dopage d'aluminium

(30) Priorität: 13.03.1992 DE 4208163
(43) Veröffentlichungstag der Anmeldung: 15.09.1993
(73) Patentinhaber: SIEMENS AKTIENGESELLSCHAFT, 80333 München (DE)
(72) Erfinder: Schulze, Hans-Joachim, Dr., W-8012 Ottobrunn (DE)

(56) Entgegenhaltungen:
- EP-A- 0 417 737
- DD-A- 207 833
- US-A- 3 145 126
- US-A- 4 199 386
- PATENT ABSTRACTS OF JAPAN vol. 6, no. 222 (E-140)6. November 1982
- JOURNAL OF THE ELECTROCHEMICAL SOCIETY Bd. 135, Nr. 1, Januar 1988, MANCHESTER, NEW HAMPSHIRE US Seiten 252 - 257 H.R. CHANG ET AL. 'Incorporation of ion-implanted Aluminium in Silicon annealed at high temperatures'
- JOURNAL OF THE ELECTROCHEMICAL SOCIETY Bd. 138, Nr. 11, November 1991, MANCHESTER, NEW HAMPSHIRE US Seiten 3427 - 3431 MASAHIDE WATANABE ET AL. 'Annealing behavior of ion-implanted Aluminium atoms in Silicon by use of capping film'
- PATENT ABSTRACTS OF JAPAN vol. 14, no. 156 (E-908)26. M rz 1990
- I. Ruge, Halbleiter-Technologie, 1975, Springer Verlag, S.100,101

## Beschreibung

Die Erfindung bezieht sich auf ein Verfahren zum Erzeugen eines Aluminium-Dotierungsprofils in einem Silizium-Halbleiterkörper durch Belegen eines oberflächennahen Bereichs des Halbleiterkörpers mit Aluminium und durch anschließendes Eintreiben des Aluminiums unter oxidierender Atmosphäre.

Dieses Verfahren wird üblicherweise dazu verwendet, bei einem n-leitenden Halbleiterkörper einen pn-Übergang mit geringem Dotierungsgradienten einzustellen. Die Beigabe von Sauerstoff zur Gasatmosphäre im Eintreibraum und die daraus folgende Bildung einer Oxid-Schicht auf der Si-Oberfläche wird im allgemeinen vorgenommen, um eine gute Qualität der Si-Oberfläche nach Abätzen dieser Oxid-Schicht zu gewährleisten. Es hat sich jedoch herausgestellt, daß das Aluminium bei dem üblichen Eintreibschritt in oxidierender Atmosphäre insbesondere dann relativ stark und inhomogen aus dem Halbleiterkörper wieder ausdiffundiert, wenn das Aluminium über eine große Strecke in der Größenordnung von 100 um in den Halbleiterkörper eingetrieben werden soll. Dies führt zur Inhomogenität der Aluminium-Randkonzentration und des Schichtwiderstandes der Al-dotierten Schicht.

Zurückführen läßt sich dieses im wesentlichen auf eine Wechselwirkung zwischen dem im oberflächennahen Bereich des Siliziums sitzenden Aluminium und der während des Eintreibens wachsenden Siliziumoxidschicht. Hierbei bildet sich auch Aluminiumoxid.

In der US 4,199,386, auf der der Oberbegriff von Anspruch 1 basiert, ist ein Verfahren zum Erzeugen eines Aluminium-Dotierungsprofils in einem Silizium-Halbleiterkörper beschrieben, bei dem der Halbleiterkörper mit Aluminium belegt wird. Dann wird eine aus Silizium bestehende Deckschicht aufgebracht, die die Wechselwirkung zwischen dem Aluminium und einer oxidierenden Atmosphäre bei einer unterhalb der Eintreibtemperatur des Aluminiums liegenden Temperatur vermindert. Anschließend wird das Aluminium -offensichtlich in oxidierender Atmosphäre- in den Halbleiterkörper eingetrieben.

Der US 4,199,386 ist zu entnehmen, daß das Aluminium bei einer Temperatur von weniger als 250° C, vorzugsweise weniger als 200° C auf das Silizium aufgebracht wird. Das heißt also, daß auf der Oberfläche des Siliziums eine Aluminiumschicht erzeugt wird, die nicht in den Silizium-Halbleiterkörper eindringen darf.

Beim nachfolgenden Erwärmen des Halbleiterkörpers auf über 800° C wird die eutektische Temperatur einer Silizium-Aluminiumlegierung (577° C) überschritten. Es bildet sich daher ab dieser Temperatur eine Schmelze mit den Komponenten Aluminium und Silizium.

Ziel der Erfindung ist es, ein Verfahren der angegebenen Art zu entwickeln, das reproduzierbare tiefe pn-Übergänge herzustellen erlaubt. Dieses Ziel wird durch die Schritte des kennzeichnenden Teils des Anspruchs 1 erreicht.

Weiterbildungen der Erfindung sind Gegenstand der Unteransprüche.

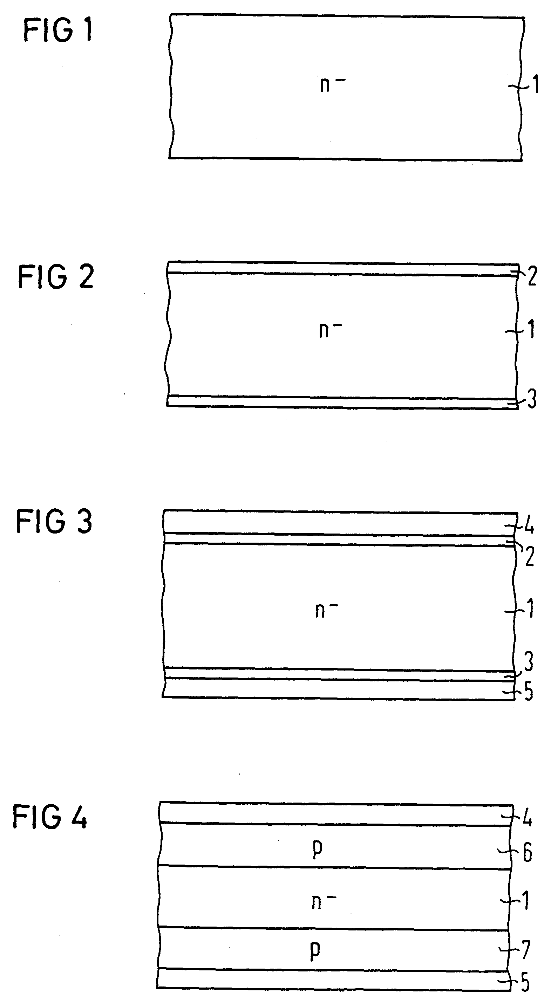

Die Erfindung wird anhand eines Ausführungsbeispiels in Verbindung mit den Figuren 1 bis 4 näher erläutert. Dabei zeigen die Figuren einen Halbleiterkörper nach charakteristischen Verfahrensschritten.

In Figur 1 ist ein n-leitender aus Silizium bestehender Halbleiterkörper 1 gezeigt. Der Halbleiterkörper 1 wird im Vakuum bei einer Temperatur von z.B. 960° C für eine Dauer von z.B. 6 Stunden mit Aluminium belegt. Dabei entstehen stark aluminiumdotierte Siliziumschichten 2, 3 (Figur 2) auf der Oberseite und Unterseite des Halbleiterkörpers 1. Diese Schichten haben beispielsweise eine Dicke zwischen 1 und 2 µm. Als nächstes (Figur 3) werden die Schichten 2 und 3 mit je einer Deckschicht 4, 5 bedeckt, die die Wechselwirkung zwischen dem Aluminium in den Schichten 2, 3 und der oxidierenden Atmosphäre des späteren Eintreibschrittes vermindern sollen. Die Schichten 4, 5 können z.B. aus Silizium bestehen, das epitaktisch abgeschieden wird. Das Silizium kann jedoch auch aufgedampft, gesputtert oder chemisch aus der Gasphase abgeschieden werden. Im Fall einer epitaktisch abgeschiedenen Schicht wächst diese monokristallin auf. Eine aufgedampfte Schicht wird im allgemeinen amorph sein, ebenso eine gesputterte Schicht. Eine chemisch aus der Gasphase abgeschiedene Siliziumschicht (CVD-Silizium) wird üblicherweise polykristallin aufwachsen. Die Schichten 4 und 5 erhalten typischerweise eine Dicke zwischen 0,5 und 10 µm. Wichtig ist, daß die Deckschichten 4 und 5 bei einer Temperatur erzeugt werden, die wesentlich unter der Eintreibtemperatur von z.B. 1240° C liegt. Für die Abscheidung nach dem CVD-Verfahren hat sich z.B. eine Temperatur von 650° C bewährt.

Zum Eintreiben des Aluminiums in den Halbleiterkörper (Figur 4) wird der Halbleiterkörper einer oxidierenden Atmosphäre ausgesetzt, die z. B. neben 5 % Sauerstoff auch Stickstoff enthalten kann. Als Temperatur kommt, wie oben erwähnt, z. B. 1240° C in Frage. Wird über z. B. 10 Stunden eingetrieben, so bilden sich p-dotierte Schichten 6, 7 von z. B. 100 um Dicke aus. Hierbei hat der Dotierungsgradient in den Schichten 6 und 7 am pn-übergang einerseits den erwünschten flachen Verlauf. Andererseits ist die Randkonzentration und der Schichtwiderstand über die Fläche des Halbleiterkörpers homogen. Die Randkonzentration und der Schichtwiderstand hängt außer von der Belegungsdosis auch von der Dicke der Deckschicht 4, 5 ab. So wurde beobachtet, daß sich die Al-Konzentration im Bereich der ursprünglichen Oberfläche des Halbleiterkörpers 1 mit Erhöhung der Dicke der Schichten 4, 5 ebenfalls erhöht und sich der Schichtwiderstand der Al-dotierten Zone erniedrigt.

Durch die Schichten 4, 5 wird die Wechselwirkung zwischen der oxidierenden Atmosphäre und dem Aluminium beim Eintreiben in den Schichten 2, 3 und somit auch die Al-Ausdiffusion aus dem Si-Kristall während des Eintreibschrittes stark vermindert. Dies läßt sich anschaulich dadurch erklären, daß im Bereich der Schichten 2, 3 beim Eintreiben kaum Oxid gebildet werden kann. Das Oxid bildet sich vielmehr im Oberflächenbereich der Deckschichten 4, 5. Der ursprüngliche Halbleiterkörper 1 selbst wird bei ausreichender Bemessung der Dicke der Schichten 4, 5 nicht zur Oxidbildung herangezogen.

In den Fällen, in denen die Schichten 4, 5 amorphe Siliziumschichten sind, empfiehlt es sich im Hinblick auf das fertige Bauelement, diese durch Tempern zu kristallisieren. Dies kann entweder durch zusätzliches Tempern bei z. B. 850° C oder direkt beim Eintreiben geschehen.

## Patentansprüche

1. Verfahren zum Erzeugen eines Aluminium-Dotierungsprofils in einem Silizium-Halbleiterkörper, durch Belegung des Halb-leiterkörpers mit Aluminium, Aufbringen einer aus Silizium bestehenden Deckschicht (4, 5) auf den belegten Halbleiterkörper bei einer unterhalb der Eintreibetemperatur des Aluminiums liegenden Temperatur zur Verminderung der Wechselwirkung zwischen dem Aluminium und einer oxidierenden Atmosphäre und nachfolgendem Eintreiben des Aluminiums in den Halbleiterkörper in der oxidierenden Atmosphäre, **dadurch gekennzeichnet**, daß der Silizium-Halbleiterkörper im Vakuum bei einer Temperatur und während einer Dauer mit Aluminium belegt wird, bei denen stark mit Aluminium dotierte Siliziumschichten (2, 3) entstehen.

2. Verfahren nach Anspruch 1,
**dadurch gekennzeichnet** , daß die stark mit Aluminium dotierten Siliziumschichten (2, 3) 1 bis 2 µm dick gemacht werden.

3. Verfahren nach Anspruch 1,
**dadurch gekennzeichnet**, daß die Silizium-Deckschicht (4, 5) eine Dicke zwischen 0,5 und 10 µm erhält.

4. Verfahren nach einem der Ansprüche 1 bis 3,
**dadurch gekennzeichnet**, daß die Silizium-Deckschicht epitaktisch abgeschieden wird.

5. Verfahren nach einem der Ansprüche 1 bis 3,
**dadurch gekennzeichnet**, daß die Silizium-Deckschicht aufgedampft wird.

6. Verfahren nach einem der Ansprüche 1 bis 3,
**dadurch gekennzeichnet**, daß die Silizium-Deckschicht gesputtert wird.

7. Verfahren nach einem der Ansprüche 1 bis 3,
**dadurch gekennzeichnet**, daß die Silizium-Deckschicht chemisch aus der Gasphase abgeschieden wird.

## Claims

1. Process for producing an aluminium doping profile in a silicon semiconductor body, by coating of the semiconductor body with aluminium, application of a silicon cover layer (4, 5) to the coated semiconductor body, at a temperature below the drive-in temperature of the aluminium, in order to reduce the interaction between the aluminium and an oxidizing atmosphere, and subsequently driving the aluminium into the semiconductor body in the oxidizing atmosphere, characterized in that the silicon semiconductor body is coated with aluminium in a vacuum at a temperature and over a time for which silicon layers (2, 3) heavily doped with aluminium are produced.

2. Process according to Claim 1, characterized in that the silicon layers (2, 3) heavily doped with aluminium are formed to a thickness of 1 to 2 µm.

3. Process according to Claim 1, characterized in that a thickness of between 0.5 and 10 µm is imparted to the silicon cover layer (4, 5).

4. Process according to one of Claims 1 to 3, characterized in that the silicon cover layer is epitaxially deposited.

5. Process according to one of Claims 1 to 3, characterized in that the silicon cover layer is vacuum-evaporated.

6. Process according to one of Claims 1 to 3, characterized in that the silicon cover layer is sputtered.

7. Process according to one of Claims 1 to 3, characterized in that the silicon cover layer is applied by chemical vapour deposition.

## Revendications

1. Procédé de production d'un profil de dopage d'aluminium dans un corps semi-conducteur en silicium, en mettant de l'aluminium sur le corps semi-conducteur d'aluminium, en déposant à une température inférieure à la température d'incorporation de l'aluminium pour empêcher l'interaction entre l'aluminium et une atmosphère oxydante une couche (4,5) de finition en silicium sur le corps semi-conducteur muni d'aluminium, puis en incorporant de l'aluminium dans le corps semi-conducteur dans l'atmosphère oxydante, caractérisé en ce que l'on met de l'aluminium sur le corps semi-conducteur en silicium dans le vide à une température et pendant une durée, pour lesquelles apparaissent des couches (2,3) de silicium fortement dopées en aluminium.

2. Procédé suivant la revendication 1,
caractérisé en ce que l'on rend les couches (2,3) de silicium fortement dopées en aluminium épaisses de 1 à 2 µm.

3. Procédé suivant la revendication 1,
caractérisé en ce que la couche (4,5) de finition en silicium acquiert une épaisseur comprise entre 0,5 et 10 µm.

4. Procédé suivant l'une des revendications 1 à 3,
caractérisé en ce que l'on dépose par épitaxie la couche de finition en silicium.

5. Procédé suivant l'une des revendications 1 à 3,
caractérisé en ce que l'on vaporise la couche de finition en silicium.

6. Procédé suivant l'une des revendications 1 à 3,
caractérisé en ce que l'on pulvérise par pulvérisation cathodique la couche de finition en silicium.

7. Procédé suivant l'une des revendications 1 à 3,
caractérisé en ce que l'on dépose la couche de finition en silicium de manière chimique en phase gazeuse.
